(19) Europäisches Patentamt / European Patent Office / Office européen des brevets

(11) **EP 3 717 893 B1**

(12) **EUROPÄISCHE PATENTSCHRIFT**

(45) Veröffentlichungstag und Bekanntmachung des Hinweises auf die Patenterteilung:
**12.01.2022 Patentblatt 2022/02**

(21) Anmeldenummer: **18815584.0**

(22) Anmeldetag: **30.11.2018**

(51) Int Cl.:
***G01N 27/04*** *(2006.01)*

(86) Internationale Anmeldenummer:
**PCT/EP2018/083172**

(87) Internationale Veröffentlichungsnummer:
**WO 2019/106158 (06.06.2019 Gazette 2019/23)**

(54) **VERFAHREN UND VORRICHTUNG ZUR BESTIMMUNG DER ELEKTRISCHEN LEITFÄHIGKEIT**

METHOD AND DEVICE FOR DETERMINING ELECTRICAL CONDUCTIVITY

PROCÉDÉ ET DISPOSITIF POUR DÉTERMINER LA CONDUCTIVITÉ ÉLECTRIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **01.12.2017 DE 102017128581**

(43) Veröffentlichungstag der Anmeldung:
**07.10.2020 Patentblatt 2020/41**

(73) Patentinhaber: **Philipps-Universität Marburg 35037 Marburg (DE)**

(72) Erfinder:
• **WEITZEL, Karl-Michael 35043 Marburg (DE)**
• **WIEMER, Jan 35037 Marburg (DE)**

(74) Vertreter: **Stumpf, Peter c/o TransMIT GmbH Kerkrader Strasse 3 35394 Gießen (DE)**

(56) Entgegenhaltungen:
**DE-A- 3 340 719 DE-A1- 4 132 562**

• **P. V. MENEZES ET AL: "Bombardment induced ion transport-Part II. Experimental potassium ion conductivities in borosilicate glass", PHYSICAL CHEMISTRY CHEMICAL PHYSICS, Bd. 13, Nr. 45, 1. Januar 2011 (2011-01-01), Seite 20123, XP055552659, ISSN: 1463-9076, DOI: 10.1039/c1cp21216h**
• **ZAKEL JULIA ET AL: "Low energy bombardment induced cesium ion transport through a sodium ion conductor: Concentration profiles and diffusion coefficients", SOLID STATE IONICS, NORTH HOLLAND PUB. COMPANY. AMSTERDAM; NL, NL, Bd. 242, 10. Mai 2013 (2013-05-10), Seiten 20-25, XP028555048, ISSN: 0167-2738, DOI: 10.1016/J.SSI.2013.04.007**
• **JAN L. WIEMER ET AL: "Remote access to electrical conductivity by charge attachment from an ambient pressure plasma", APPLIED PHYSICS LETTERS, Bd. 113, Nr. 5, 30. Juli 2018 (2018-07-30) , Seite 052902, XP055552459, US ISSN: 0003-6951, DOI: 10.1063/1.5045530**

EP 3 717 893 B1

# Beschreibung

Die vorliegende Erfindung betrifft ein Verfahren zur Bestimmung der elektrischen Leitfähigkeit unter Verwendung von Niederdruck-, Normaldruck- oder Hochdruck-Plasma als Ionenquelle, sowie eine Vorrichtung zur Durchführung des Verfahrens. Als "Plasma" werden nachfolgend Systeme bezeichnet, die aus freien geladenen Teilchen beider Polaritäten bestehen und deren Eigenschaften sich hauptsächlich von den enthaltenen Ladungsträgern ableiten. Als Atmosphärendruckplasmen (synonym: Normaldruckplasmen) werden nachfolgend Plasmen angesehen, die - unabhängig von der jeweiligen Atmosphäre und ohne Festlegung auf eine bestimmte chemische Zusammensetzung der Atmosphäre bei einem Absolutdruck von etwa $10^5$ Pa erzeugt und/oder unterhalten werden. Insgesamt umfasst die vorliegende Erfindung Plasmen bei Drucken von etwa 0.1 Pa bis $10^{11}$ Pa.

## Stand der Technik

Die Messung des elektrischen Widerstandes erfolgt bekanntermaßen durch sogenannte Zweipunkt- oder Vierpunkt-Messungen, je nachdem, welche Genauigkeit mit den Messergebnissen erreicht werden soll. Die dazu verwendeten Schaltkreise und Verfahrensparameter sind dem Fachmann bekannt. Es ist folglich im Stand der Technik zwingend erforderlich, mindestens zwei Messelektroden elektrisch leitend mit der Probe zu verbinden, deren Widerstand gemessen werden soll. Dies ist umso nachteiliger je komplizierter es ist, die elektrische Kontaktierung der Messelektroden an der Probe vorzunehmen (beispielsweise an dünnen Schichten), so dass Bedarf an einer Messmethode besteht, die mit weniger Elektrodenkontakten auskommt.

Unter Hochvakuum-Bedingungen ist es bereits gelungen, einen Ionenstrahl anstelle einer soliden Elektrode als Messelektrode (Messkontakt) zu verwenden (vgl. M. Schäfer und K.-M. Weitzel, Phys. Chem. Chem. Phys., 2011, 13, 20112-20122; P. V. Menezes et al., Phys. Chem. Chem. Phys., 2011, 13, 20123-20128). Dieses Verfahren (Vakuum-BIIT = Bombardement induzierter Ionen-Transport im Vakuum") ist jedoch sehr aufwendig und komplex, da es nur unter Verwendung eines thermionisch erzeugten Ionenstrahls und unter Hochvakuumbedingungen durchführbar ist.

Detailliert beschrieben worden ist dieses Verfahren auch im Rahmen der "2013 IEEE International Conference on Solid Dielectrics", die in Bologna (Italien) vom 30.6.13 bis zum 4.7.13 stattfand. Demzufolge ist es im Stand der Technik bekannt, die Ionenleitfähigkeiten von Calciumphosphatgläsern zu bestimmen, indem die Proben kontinuierlich mit einem entsprechenden Ionenstrahl ($K^+$ / $Rb^+$) bestrahlt werden, und dabei der über eine Massenelektrode abfließende Strom gemessen wird. Ursprünglich diente der entsprechende Aufbau der Untersuchung von Phänomenen des Ionentransports von Kalium- und Rubidium-Kationen in den betreffenden Gläsern; die Bestimmung der Ionenleitfähigkeit (begrenzt auf $K^+$ und $Rb^+$) ergibt sich dabei als Nebeneffekt, der jedoch zwingend die Bestrahlung der Probe mit dem entsprechenden Ionenstrahl im Hochvakuum ($\leq 2 \cdot 10^{-6}$ mbar) verlangt.

Unter Normaldruck-Bedingungen ist der Einsatz von thermionisch erzeugten Ionenstrahlen nicht möglich. Plasmen können jedoch nicht nur im Vakuum, sondern auch unter Normaldruck sowie darüber hinaus erhöhtem Druck erzeugt und gehandhabt werden.

In der DE 41 32 562 A1 wird ein Verfahren zur in-situ Bestimmung des Schichtwiderstandes von dünnen elektrisch leitenden Schichten während der Abscheidung durch das Plasma beschrieben. Das dort beschriebene Verfahren erfolgt zwingend unter Vakuumbedingungen und die Autoren weisen explizit darauf hin, dass es nicht möglich ist, den vom Plasma auf das Messobjekt induzierten Strom direkt zu ermitteln. Eine Lösung dieses Problems wird weder offenbart noch nahegelegt. Auf bereits vorhandene Materialproben ist das Verfahren nicht anwendbar. Der Messaufbau und das Verfahren in DE 41 32 562 A1 sind auch deutlich komplexer und schwieriger realisierbar als das hierin nachfolgend beschriebene Verfahren sowie die zugehörige Vorrichtung.

In der Publikation "Charge attachment induced transport - bulk and grain boundary diffusion of potassium in $PrMnO_3$" (Phys. Chem. Chem. Phys., 2017, 19, 9762-9769) ist beschrieben, daß die Leitfähigkeit von Materialien mit Perowskit-Struktur ($ABO_3$) ebenfalls mittels der vorstehend beschriebenen Vakuum-BIIT bestimmt werden kann, wobei das hierin beschriebene Verfahren ebenfalls nur im Hochvakuum, d.h. $\leq 2 \cdot 10^{-6}$ mbar, und mittels Ionenstrahlen durchgeführt werden kann, und damit nach wie vor großen Beschränkungen unterliegt.

Ein weiteres häufig verwendetes Verfahren zur Analyse von Leitfähigkeiten ist die Impedanzspektroskopie. Aber auch dieses Verfahren ist zwingend auf die Verwendung von mindestens zwei direkt elektrisch leitend mit der Probe verbundenen Messelektroden angewiesen. Neben dieser bestehen weitere Verfahren, wie die Tracer-Diffusion oder den bereits erwähnten Vakuum-BIIT.

Eine berührungslose Messung von lokalen Unterschieden in Schichtwiderständen, bzw. Schicht-Leitfähigkeiten (nicht aber absoluten Leitfähigkeiten) gelingt zwar auch unter Ausnutzung des Wirbelstrom-Effektes, allerdings muß hierbei der Meßkopf in genau bekanntem, wohldefiniert konstanten und geringen Abstand über der zu messenden Oberfläche gleichmässig hinweggeführt werden, was die Einsatzmöglichkeiten dieses Verfahrens drastisch einschränkt. Geräte dafür bietet z. B. die Fa. Suragus GmbH an.

## Aufgabe

Aufgabe der vorliegenden Erfindung ist es, die wie vorstehend beschrieben im Stand der Technik bestehenden Nachteile von Widerstands- bzw. Leitfähigkeitsmessungen an einer Probe zu überwinden. Neben der Reduzierung der Anzahl der für die Messung zu verwendenden Elektroden ist u.a. auch die Durchführung bei Absolutdrucken größer als ca. $2 \cdot 10^{-6}$ mbar gegenüber Verfahren wie der Vakuum-BIIT eine durch die Erfindung gelöste Aufgabe.

**Lösung der Aufgabe**

Diese Aufgabe wird erfindungsgemäß gelöst durch Verwendung eines Plasmas - sowohl unter Normaldruck/Atmosphärendruck als auch bei höherem oder niedrigerem Druck - zur Übertragung einer definierten Ladung auf die Probe sowie die Aufprägung des für die Messung erforderlichen definierten Spannungspotentials auf die zu messende Probe. Das erfindungsgemäße Verfahren gestattet es, bei Messungen unter Normaldruck die Anzahl der erforderlichen Messelektroden zu reduzieren sowie auch die Messung aus größerer Distanz durchzuführen. Die Erfindung umfasst ebenfalls eine Vorrichtung zur Durchführung des Verfahrens. Die Begriffe "Spannung" und "Potenzial" werden im weiteren synonym verwendet, beispielsweise wenn von der "Spannung an der Gegenelektrode" oder dem "Potential an der Gegenelektrode" die Rede ist. Dezimalzahlen werden nachfolgend unter Verwendung eines Dezimalpunktes angegeben.

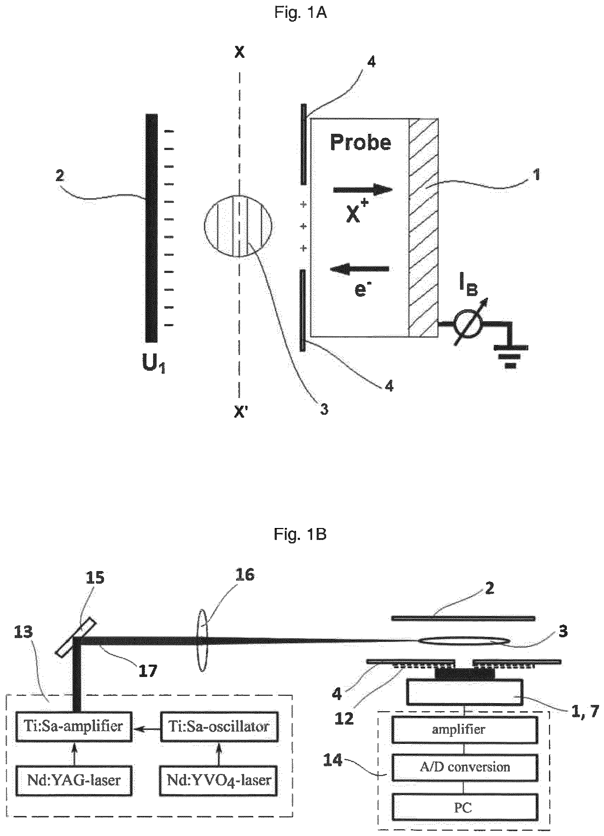

Eine Ausführungsform dieser Vorrichtung zur Durchführung des Verfahrens ist beispielhaft in Fig. 1A gezeigt. Sie umfasst eine Messelektrode 1, die mit der Rückseite der Probe elektrisch leitend verbunden ist, eine Gegenelektrode 2, an die ein Potenzial $U_1$ angelegt werden kann, das gegenüber dem Massepotenzial, auf dem sich die Messelektrode befindet, positiv oder negativ sein kann, eine Maske 4, mit Hilfe derer die Größe der Kontaktfläche des Plasmas mit der Probe festgelegt wird, wobei an diese Maske 4 je nach Ausführungsform des Verfahrens ein Potenzial $U_2$ angelegt werden kann, das ebenfalls positiv oder negativ gegenüber dem Massepotenzial (oder auch gleich dem Massepotenzial) sein kann, und eine Vorrichtung zur Erzeugung des Plasmas 3, die der Übersichtlichkeit halber in Fig. 1A nicht gezeigt ist. Jede dem Fachmann bekannte Vorrichtung zur Erzeugung eines Plasmas - sowohl unter Normaldruck/Atmosphärendruck als auch bei höherem oder niedrigerem Druck - kann erfindungsgemäß verwendet werden. Bei Verwendung eines Lasers zur Erzeugung des Plasmas ist es beispielsweise vorteilhaft, wenn der Laser so angeordnet wird, dass der Laserstrahl in geeignetem Abstand (beispielsweise ca. 5mm) zur Probenoberfläche parallel zu dieser zwischen der Gegenelektrode 2 und der vorderen Probenoberfläche verläuft, was in Fig. 1A durch die gestrichelte Linie X-X' angedeutet ist. Es ist ohne weiteres ersichtlich und fällt daher in den Umfang der Erfindung sowie Ihrer Äquivalente, dass es das erfindungsgemäße Verfahren ermöglicht, die Messung von Leitfähigkeiten über eine größere Distanz hinweg durchzuführen: Die Vorrichtung zur Erzeugung des Plasmas (z. B. ein Laser) kann sich weit entfernt von der Probe befinden, ggf. auch außerhalb einer Apparatur, in der sich die zu messende Probe befindet, während das Plasma in der Nähe der Probe entsteht und dadurch eine Messung auf Distanz ermöglicht. Es muß kein - wie auch immer gearteter Meßkopf zur Probe hingeführt oder gar in Kontakt mit ihr gebracht werden. Lediglich der rückseitige Massekontakt (Messelektrode 1) der Probe ist erforderlich. Die Maske 4 kann in direktem Kontakt zur Probe angeordnet sein oder sich in geeignet geringem Abstand zur Probenoberfläche befinden. Die in Fig. 1A gezeigte Polarität ist beispielhaft gewählt; eine entgegengesetzte Polarität ist ebenfalls möglich und erfindungsgemäß.

Fig. 1B zeigt eine weitere Ausführungsform, die insbesondere den Aspekt der Distanzmessung verdeutlicht. In Fig. 1B sind weitere periphere Bauteile wie ein Lasersystem 13 und Vorrichtungen zur Datenaufnahme und Datenauswertung 14 beispielhaft schematisch dargestellt. Probenhalter 7 und Messelektrode 1 sind der Einfachheit halber in Fig. 1B zusammengefasst. Ausgehend vom Lasersystem 13 wird Laserstrahl 17 zunächst beispielhaft durch den Umlenkspiegel 15 in Richtung der Probenoberfläche umgelenkt und anschließend - soweit erforderlich - durch die Linse 16 fokussiert, so dass sich das Plasma in geringem Abstand zur Probenoberfläche im Bereich des durchlässigen Teils der Masken 4, 12 ausbildet. Die Entfernung sowie Positionierung des Lasersystems gegenüber der Probe ist weitgehend frei wählbar, da der Laserstrahl auch über größere Entfernungen hinweg unter ggf. Verwendung weiterer Spiegel und optischer Linsen geeigneter Brennweiten, beispielsweise f=40 cm für Linse 16 im Rahmen einiger Ausführungsbeispiele, beliebig geführt werden kann. Die erforderlichen Stromzuführungen sind der Übersichtlichkeit halber in Fig. 1A und Fig. 1B nicht gezeigt.

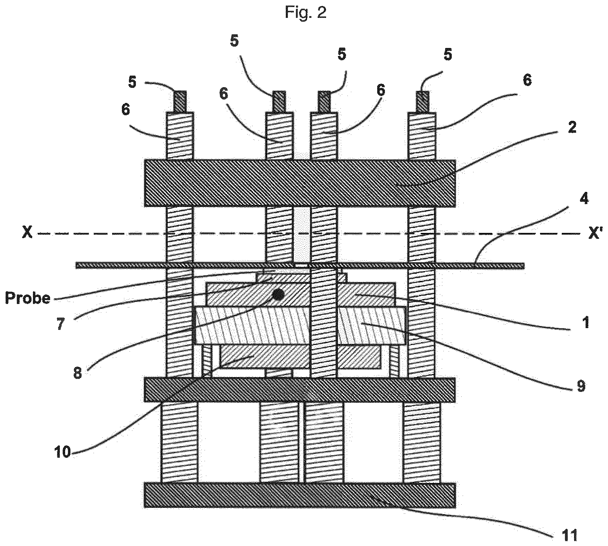

Fig. 2 zeigt eine Prinzip-Skizze der für die Ausführungsbeispiele verwendeten Vorrichtung. Neben den in Fig. 1A bereits gezeigten Merkmalen weist diese Ausführungsform weitere beispielhaft ausgewählte Merkmale auf, nämlich: ein die Vorrichtung stablisierendes Gestänge 5 mit Isolationselementen 6, die zugleich auch als Abstandshalter dienen, einen Probenhalter 7, einen Temperaturfühler 8 (Pt100-Element), einen Korundblock 9, eine Heizung 10 sowie eine Grundplatte 11, auf der die gesamte Vorrichtung ruht. Es ist offensichtlich, dass bei dieser Ausführungsform der Probenhalter 7 ebenfalls elektrisch leitend sein muß, da die Messelektrode 1 hier nur über den Probenhalter 7 elektrisch leitend mit der Probe in Kontakt tritt. In dieser Ausführungsform wird der Probenhalter somit zu einem Teil der Messelektrode 1. Andere Varianten des Probenhalters sind ebenfalls möglich, etwa, dass die Probe an den Seiten von dem Probenhalter 7 gehalten wird, wobei dann der Probenhalter 7 nicht elektrisch leitend sein muß, weil dann die Probenunterseite elektrisch leitend in Kontakt mit der Messelektrode 1 gebracht werden kann. Mit dem Temperaturfühler **8** wird die Probentemperatur überwacht und die Heizung **10** gesteuert oder geregelt, der Korundblock **9** dient der thermischen Kontaktierung von Heizung **10** und der Probe bei gleichzeitiger elektrischer Isolierung von Heizung **10** und Probe bzw. Messelektrode **1**. Die erforderlichen Stromzuführungen sind der Übersichtlichkeit halber in Fig. **2** ebenfalls nicht gezeigt; auch hier markiert die gestrichelte Linie X-X' die Strahlführung bei Verwendung eines Lasers zur Erzeugung des Plasmas.

Eine Möglichkeit zur Erzeugung eines künstlichen Plasmas unter Normaldruck ist - wie bereits vorstehen erwähnt - die Fokussierung eines intensiven, gepulsten Laserstrahls, wodurch die Luft (bzw. allgemeiner: die Gasatmosphäre) im Fokusbereich ionisiert und damit ein Plasma erzeugt wird. Es ist für den Fachmann naheliegend und fällt daher in den Umfang der Erfindung sowie ihrer Äquivalente, Plasmen für das hier beschriebene Verfahren auch auf andere Art und Weise zu erzeugen, beispielsweise durch kontinuierlich emittierende Laser (cw-Laser), Mikrowellenstrahlung u.a.m.

Das hier offenbarte Prinzip der Widerstands- bzw. Leitfähigkeitsmessung beruht auf der BIIT-Technologie, jedoch unter Verwendung eines Plasmas anstelle eines Ionenstrahls und im Feinvakuum, unter Normaldruck oder sogar auch bei erhöhtem Druck statt im Hochvakuum.

Bei der Erzeugung des Plasmas werden primär Elektronen/Kationenpaare erzeugt. Wesentliches Merkmal ist, dass immer genau so viele positive wie negative Ladungen freigesetzt werden (Erhaltung der Gesamtladung, das Medium ist vor der Plasmazündung neutral, es werden von außen keine Ladungsträger eingebracht). Die positiven und negativen Ladungsträger werden im elektrischen Feld getrennt. Je nach Polarität der Gegenelektrode **2** bewegen sich entweder die positiven oder die negativen Ladungsträger auf die Probenoberfläche zu und laden diese positiv oder negativ auf.

Je nach Druck im Bereich der Plasmaquelle kann es zu Sekundärreaktionen der Ladungsträger kommen. Z.B. reagieren Primärelektronen i.d.R. sehr schnell mit Sauerstoff zu Sauerstoff-Anionen. Die Gesamtmenge der negativen Ladungsträger wird dadurch nicht verändert. Die erreichte Oberflächenladung bzw. das Oberflächenpotenzial wird demzufolge auch nicht verändert.

Das Verfahren beruht auf der Aufladung einer Oberfläche der zu messenden Probe durch ein damit in Kontakt befindliches Plasma durch die Anlagerung von Ladungsträgern aus dem Plasma heraus. Hierfür wird die Bezeichnung CAIT (charge attachment induced transport) gewählt, jedoch mit der Ergänzung "Plasma" (Plasma-CAIT), womit zum Ausdruck gebracht wird, dass - im Gegensatz zum Vakuum-BIIT - ein Hochvakuum nicht erforderlich ist, sondern die Messung in einem sehr weiten Druckbereich durchführbar ist, innerhalb dessen sich der Normaldruck-Bereich befindet. Je nach Polung der Gegenelektrode gegenüber dem Massepotenzial, auf dem sich die mindestens eine in elektrisch leitfähigem Kontakt mit der Probe befindliche Messelektrode befindet, kann die Probenoberfläche sowohl positiv als auch negativ aufgeladen werden. Entgegen der ursprünglich gewählten Namensgebung läuft jedoch auch bei allen BIIT-Varianten eher eine Anlagerung als ein Bombardement ab. Zur Abgrenzung wird daher im weiteren Verlauf einerseits von Vakuum-BIIT andererseits von Plasma-CAIT gesprochen. Dadurch baut sich ein Potenzialgradient gegenüber der Probenrückseite auf, die mit einer geerdeten Elektrode elektrisch leitend in Kontakt steht. Dieser Messkontakt (Messelektrode) ist der einzige zwingend erforderliche "klassische" Messkontakt zur Probe. Als "klassische" Messkontakte werden elektrisch leitende Kontakte bezeichnet, die in bekannter Weise gemäß dem Stand der Technik realisiert sind, also etwa durch Löten, Schweißen, Bonden, Klemmen, Schrauben usw. Demgegenüber handelt es sich bei einem erfindungsgemäßen "nicht-klassischen" Messkontakt um eine elektrisch leitende Verbindung über die Gasphase (also via Plasma) zur Probe hin. Kontaktierungsverfahren wie die vorstehend genannten sind dabei nicht erforderlich, was die Kontaktierung der Probe sehr erleichtert. Natürlich kann auch mehr als ein klassischer Messkontakt in Verbindung mit einem nichtklassischen Messkontakt verwendet werden, ohne den Umfang der Erfindung oder ihrer Äquivalente zu verlassen, um z.B. den Widerstand der Messleitung zum klassischen Messkontakt zu erfassen und zu berücksichtigen. Es wird in jedem Falle immer eine Verfahrensvariante erhalten, die mindestens einen klassischen Messkontakt weniger benötigt als das entsprechende Verfahren gemäß dem Stand der Technik. Erfindungsgemäß wird z. B. gegenüber einer Zweipunkt-Messung ein klassischer Messkontakt weniger benötigt. Gleiches gilt analog auch für andere Mehrpunkt-Messungen, etwa Vierpunktmessungen. Die an der Gegenelektrode **2** angelegte Spannung wird nachfolgend auch als "Quellspannung des Plasmas" bezeichnet. Die nichtklassische Kontaktierung der Probe durch das Plasma erfolgt bereichsweise, d.h. flächig, wohingegen die klassische Kontaktierung durch die Messelektrode sowohl bereichsweise (flächig) als auch punktuell (s.o.) erfolgen kann; eine bereichsweise Kontaktierung wird beispielsweise erreicht durch Andrücken der Probe an eine Kontaktfläche der Messelektrode oder durch Andrücken an eine Kontaktfläche einer mit der Messelektrode elektrisch leitend verbundenen Probenaufnahme (Probenhalter) **7**. Zur Reduzierung des Kontaktwiderstandes kann dabei auch Leitfähigkeitspaste o. dgl. im Bereich der Kontaktflächen von Probenaufnahme **7** und Messelektrode **1** verwendet werden.

Aufgrund der im vorstehenden Absatz bereits offenbarten Möglichkeit, die Polung der Gegenelektrode frei zu wählen, kann das vorliegenden Verfahren grundsätzlich auch mit Wechselstrom durchgeführt werden. Dies fällt daher ebenfalls in den Umfang der Erfindung sowie ihrer Äquivalente.

In Folge der nicht-klassischen Kontaktierung der Probe durch das Plasma setzt eine Wanderung mobiler Ladungsträger ein, welche an der Probenrückseite infolge des Massenkontaktes neutralisiert werden (mobile Kationen im Fall positiver Aufladung bzw. mobile Anionen im Fall negativer Aufladung bei Elektrolyten, Elektronen bzw. "Löcher" im Falle von Halbleitern, Elektronen bei metallischen Leitern). Durch Messen dieses Neutralisationsstromes $I_B$ können Rückschlüsse über die Leitfähigkeit der verwendeten Probe getroffen werden. Neben einer Anlagerung von Ionen können Proben bei der Vakuum-BIIT zudem auch mit Elektronen beschossen werden. Alle bisher bekannten Varianten von BIIT benötigen einen experimentellen Aufbau im Hochvakuum. Nur dadurch können Ionen- bzw. Elektronenstrahlen mit definierten kinetischen Energieverteilungen erzeugt werden, da ansonsten aufgrund von Stößen eine Thermalisierung einsetzen würde. Überraschendweise wurde nun gefunden, dass Plasmen auch unter Normaldruck verwendet werden können, um eine Materialprobe nichtklassisch elektrisch leitend über die Gasphase hinweg zu kontaktieren. Entgegen der Situation im Vakuum, wo eine Thermalisierung nicht oder zumindest in deutlich geringerem Umfange stattfindet, ist sie bei der Plasma-CAIT ein wesentlicher Effekt und vorteilhaft für die Durchführung der Leitfähigkeitsmessung. Bei der Thermalisierung findet eine Auskühlung des Plasmas statt, so dass die Probe weniger thermisch belastet wird. Im Rahmen der Thermalisierung reagieren die aus den Gasmolekülen herausgeschlagenen Elektronen mit Gasmolekülen zu anionischen Spezies; im Falle eines Normaldruck-Plasmas in Umgebungsluft entsteht so bevorzugt $O_2^-$. Neben der überraschenderweise für die Probenoberfläche nicht schädlichen durch die Thermalisierung sich einstellenden Plasmatemperatur ist - ebenso überraschend - die aus der Plasmaerzeugung resultierende Schockwelle ebenfalls nicht schädlich für die zu messende Probe.

Neben den vom Lasersystem vorgegebenen Parametern (Intensität und Strahlbreite), beruht das Phänomen physikalisch auf dem Gleichgewicht von drei Parametern:

- externe Fokussierung,
- Selbstfokussierung durch den KERR-Linsen-Effekt, welcher auch bei ausreichenden Intensitäten an Luft auftritt, und
- Defokussierung durch die einsetzende Ionisierung der Luft (allgemeiner: der umgebenden Gasatmosphäre).

Eine starke externe Fokussierung des Laserstrahls führt zu einer hohen Intensität, welche in einer hohen Plasmadichte resultiert. Gleichzeitig bleibt die Einstellung eines Gleichgewichts zwischen Fokussierung und Defokussierung aus. Es bildet sich dann kein Filament, sondern ein lokales Plasma mit geringer longitudinaler und vertikaler Ausbreitung. Bei entsprechend gewählter Brennweite der Fokuslinse stehen alle drei vorherig beschriebenen Effekte im Gleichgewicht. Dies erklärt sowohl die größte vertikale Ausbreitung, welche bei größeren Brennweiten zunehmend abnimmt, als auch die abnehmenden maximalen Plasmadichten. Ab einem gewissen Schwellenwert, welcher bei jeder Brennweite anders ist, führt eine Erhöhung der Laserleistung nur noch zu geringfügig höheren Plasmadichten. Über die Wahl der Laserparameter sowie der Umgebungsparameter wie Druck, Temperatur, Gasdruck usw. können Form und Position des Plasmas der Meßaufgabe entsprechend angepasst werden.

Für das erfindungsgemäße Verfahren ist ein möglichst hoher Ionenstrom bei unterschiedlichen elektrischen Feldern erwünscht. Für laserinduzierte oder andersartig erzeugte Plasmen sind bislang keine spezifischen Gesetze der Emission in Abhängigkeit der angelegten Felder abgeleitet worden. Die hier diskutierten Ergebnisse sowie die, wie weiter unten erläutert, ermittelten Anpassungsfunktionen an die Messdaten legen ein Verhalten nach dem Raumladungsgesetz von CHILD und LANGMUIR nahe.

Ermöglicht wird dieses Verhalten beispielhaft, jedoch nicht darauf eingeschränkt, durch ein fs-Laser induziertes Luftplasma als Ionenquelle. Zur Ermittlung von spezifischen Leitfähigkeiten ist eine Kalibrierung des effektiven, von dem Potenzial der Gegenelektrode abweichenden Oberflächenpotentials der Probe unter Verwendung eines Kalibrier-Widerstandes erforderlich, dessen Widerstandswert R in der gleichen Größenordnung liegt wie derjenige der zu messenden Probe. In den Ausführungsbeispielen wurde dazu ein 3.11 GΩ Widerstand verwendet. Neben Lasern gibt es weitere Quellen zur Erzeugung von hoch- und niederenergetischen Atmosphärendruckplasmen. Hierzu zählen unter anderem Plasmajets. Weiterhin werden Plasma-Entladungen zum Beispiel auch durch Anregung mittels Gleich-oder Wechselspannung, oder auch durch Mikrowellen erzeugt. Die Verwendung all dieser sowie weiterer im Stand der Technik bekannter Verfahren zur Erzeugung von Atmosphärendurck-(Normaldruck-)plasmen fällt in den Umfang der Erfindung sowie ihrer Äquivalente.

Die Grundlagen der Vakuum-BIIT gelten sinngemäß analog auch für Plasma-CAIT, beispielsweise hinsichtlich der kinetischen Energie ($E_{kin}$) der aus dem Plasma an die Oberfläche angelagerten Ionen. Für diese gilt in Abhängigkeit von der an die Gegenelektrode **2** angelegten Spannung $U_1$:

$$E_{kin} = F_{cal} \cdot e \cdot U_1 \qquad (Gl. 1),$$

wobei es sich bei $F_{cal}$ um einen experimentell zu bestimmenden Kalibrierfaktor handelt.

Durch die aus dem Plasma auf der Probenoberfläche auftreffenden Ionen wird diese aufgeladen. Ist der Ionenstrom vom Plasma auf die Probenoberfläche ausreichend groß, entspricht das entstehende Oberflächenpotential ($\varphi_{OF}$) auf der Probe der an der Gegenelektrode **2** angelegten Spannung, unter Berücksichtigung des ebenfalls experimentell zu ermittelnden Kalib-

rierfaktors F'$_{cal}$.

$$\varphi_{OF} = F'_{cal} \cdot U_1 \qquad (Gl.\ 2)$$

Gegenüber der geerdeten Rückseite der Probe bildet sich ein Potenzialgradient aus. Dies induziert gemäß den dem Fachmann bekannten Gesetzmäßigkeiten der Ionenleitung im Festkörper bei positiver Aufladung der Probenvorderseite eine Wanderung beweglicher kationischer Ladungsträger in der Probe hin zur Rückseite. An dieser werden sie dann von einem folgend als Rückseitenstrom (I$_B$) bezeichneten Elektronenstrom neutralisiert. Bei negativer Aufladung der Vorderseite wandern kationische Ladungsträger entsprechend zur Probenvorderseite und es findet auch hierbei wieder ein analoger Ladungsausgleich durch den entsprechend gerichteten Rückseitenstrom I$_B$ statt.

Eine Wandlung der häufig sehr geringen Ströme in eine messbare Größe erfolgt mit Hilfe eines Transimpedanzverstärkers (TIV). Im Bereich kleiner Spannungen an der Gegenelektrode wird für die Neutralisation der Ladungsträger nach einer kurzen Einstellphase ein OHMsches Verhalten beobachtet. Aus Rückseitenstrom und Spannung an der Gegenelektrode kann somit die Leitfähigkeit ($\sigma$) einer Probe bestimmt werden (ggf. unter Berücksichtigung eines Kalibrierfaktors):

$$\sigma = 1 / R \sim I_B / U_1 \qquad (Gl.\ 3)$$

Die spezifische Leitfähigkeit der Probe ($\sigma_{spez}$) ergibt sich durch Normierung auf die Fläche A (Plasmaquerschnitt an der Probenoberfläche, definiert durch die Maske 4) und die Dicke d der Probe über die Beziehung:

$$\sigma_{spez} = \sigma \cdot d / A \qquad (Gl.\ 4)$$

Das "Zünden" eines Plasmas setzt faktisch ein gasförmiges Medium voraus. Die chemische Natur dieses Mediums (Sauerstoff, Stickstoff, Luft, Edelgas, etc.) bestimmt demzufolge auch die chemische Natur der Ladungsträger. Für die wie vorstehend beschrieben ermittelbare Leitfähigkeit ist die Natur der Ladungsträger jedoch unerheblich, weil dabei im wesentlichen die faktisch erreichte Oberflächenladung den elektrischen Potenzialgradienten über die Probe bestimmt. Bei längerer Versuchsdurchführung (bei "Langzeit-Plasma-Anlagerungs-Experimenten") findet man jedoch durchaus einen Einfluß der chemischen Natur der Ladungsträger. Es handelt es sich um einen zusätzlichen Beitrag eines Gradienten des chemischen Potenzials, der natürlich von der Art der chemischen Spezies abhängt, die als Ladungsträger fungiert. Hervorgerufen wird dieser Gradient - nach gegenwärtigem Kenntnisstand und ohne diesbezüglich an eine konkrete Theorie gebunden zu sein - durch Einlagerung probenfremder Ladungsträger aus dem Plasma in die Probe. Beispielsweise können bei Verwendung eines in Stickstoff generierten Plasmas N$_2^-$-Ionen aus dem Plasma in eine oxidische Probe eingelagert werden und dort die originären Ladungsträger (O$_2^-$) ersetzen, was sich langfristig auf die Leitfähigkeit auswirkt. Dieser Effekt ist in den Konzentrationsprofilen, die typischerweise nach einem Langzeit-Plasma-Anlagerungs-Experiment gemessen werden erkennbar. Dort sieht man dann den Einfluss der chemischen Identität des Ladungsträgers. Aus dem vorstehend Gesagten geht hervor, dass es für das Verfahren unerheblich ist, in welcher Gasmischung das Plasma für die Leitfähigkeitsmessung erzeugt wird, und dass bei längeren Messungen der sich einstellende Einfluß der Gasatmosphäre durch entsprechende Kalibrierungen berücksichtigt werden kann, ohne dadurch den Umfang der Erfindung oder ihrer Äquivalente zu verlassen.

Das erfindungsgemäße Verfahren ist sowohl in der Ausführungsform mit Berücksichtigung der Plasma-Kontaktfläche A (also für die Bestimmung der spezifischen Leitfähigkeit) als auch in der Ausführungsform ohne Berücksichtigung der Plasma-Kontaktfläche A (also für lediglich die Bestimmung der lokalen Leitfähigkeit/des lokalen Leitwertes) von großer technischer Relevanz. Letztere Variante ist beispielsweise wichtig im Bereich der Qualitätskontrolle im Rahmen der Herstellung von dünnen Filmen (z.B. Separatorfolien für Akkumulatoren), wo u. U. weniger die lokale absolute spezifische Leitfähigkeit gefragt ist, sondern lediglich überprüft werden soll, ob die Schicht (Folie) lokal einen Kurzschluss aufweist, um Fertigungsfehler zu detektieren. Genau dies ermöglicht das hier offenbarte Verfahren in der Ausführungsvariante zur Bestimmung des Leitwerts: Ein Produktionsfehler wird problemlos anhand der lokalen Änderung des elektrischen Widerstands an der betreffenden fehlerhaften Stelle erkannt.

Auch im Forschungsbereich kann das erfindungsgemäße Verfahren vorteilhaft verwendet werden, z.B. zur Untersuchung der Leitfähigkeit einer Probe in Abhängigkeit von einzelnen oder mehreren Bestandteilen der umgebenden Atmosphäre, etwa von Feuchtigkeit. Ermöglicht wird dies durch die einfache gas-/vakuumdichte sowie ggf. druckfeste Einhausung der Vorrichtung und Einstellung der Atmosphäre im Inneren der Verkapselung. Besonders vorteilhaft läßt sich so die Leitfähigkeit von Flüssigkeitsschichten unter dem Einfluß diverser Gasatmosphären untersuchen.

Das erfindungsgemäße Verfahren läßt sich daher zusammenfassend wie folgt beschreiben: Es handelt sich um ein Verfahren zur Bestimmung der elektrischen Leitfähigkeit eines festen oder flüssigen Materials, das dadurch gekennzeichnet ist, dass die Probe des Materials, an der die elektrische Leitfähigkeit gemessen wird, an einer ersten Stelle punktuell oder bereichsweise mit mindestens einer Messelektrode elektrisch leitend kontaktiert wird, und an einer zweiten Stelle bereichsweise mit einem Plasma in Berührung gebracht wird, so dass die Probe durch das Plasma definiert elektrisch aufgeladen wird, und die elektrische Aufladung der Probe über die mindestens eine Messelektrode abgeleitet wird, wobei die Strommessung an der mindestens einen Messelektrode erfolgt, und die Bestimmung der Messspannung durch Berechnung des bestehenden Spannungsabfalls über die Probe aus der Quellspannung des Plasmas erfolgt.

Die im vorstehenden Absatz beschriebene an einer ersten Stelle punktuell oder bereichsweise mit mindestens einer Messelektrode elektrisch leitend erfolgende Kontaktierung des festen oder flüssigen Materials kann entweder reversibel oder irreversibel erfolgen. Weiterhin kann diese Kontaktierung des festen oder flüssigen Materials mit der mindestens einen Messelektrode direkt oder über mindestens einen Probenhalter (ebenfalls reversibel oder irreversibel) erfolgen, wobei der Probenhalter dafür über eine entsprechend ausreichend gute und bekannte elektrische Leitfähigkeit verfügt.

In einer weiteren Ausführungsform zeichnet sich das Verfahren dadurch aus, dass es bei einem Absolutdruck von $10^{11}$ Pa bis 0.1 Pa, bevorzugt bei einem Absolutdruck von $10^9$ Pa bis 10000 Pa, besonders bevorzugt bei einem Absolutdruck von $10^7$ Pa bis 50000 Pa und ganz besonders bevorzugt bei einem Absolutdruck von $0.5 \cdot 10^6$ Pa bis 70000 Pa durchgeführt wird.

In einer weiteren Ausführungsform zeichnet sich das Verfahren dadurch aus, dass es sich bei dem verwendeten Plasma um ein Atmosphärendruck-Plasma handelt.

In einer weiteren Ausführungsform zeichnet sich das Verfahren dadurch aus, dass das Plasma in Umgebungsluft oder in einer Gasmischung, die die Zusammensetzung von Umgebungsluft aufweist, erzeugt wird.

In einer weiteren Ausführungsform zeichnet sich das Verfahren dadurch aus, dass es in einer Gasmischung durchgeführt wird, deren Zusammensetzung sich von der Zusammensetzung der natürlichen Atmosphäre unterscheidet.

Das Verfahren umfasst die Erzeugung des Plasmas mit beliebigen im Stand der Technik bekannten Vorrichtungen oder Verfahren, insbesondere die Erzeugung des Plasmas mit Hilfe von Lasern, Mikrowellen, Hochfrequenzspannung, Trioden-Anordnungen u.a.m.

In einer weiteren Ausführungsform zeichnet sich das Verfahren dadurch aus, dass es sich bei dem festen oder flüssigen Material um eine Oberflächenschicht handelt.

Die Erfindung umfasst weiterhin die Verwendung des Verfahrens wie vorstehend beschrieben zur Bestimmung des Widerstandes oder der Leitfähigkeit einer Oberfläche.

Die Erfindung umfasst weiterhin die Verwendung des Verfahrens wie weiter oben beschrieben zur Bestimmung des Volumen-Widerstandes oder der Volumen-Leitfähigkeit einer Probe oder eines Teils einer Probe. In diesem Zusammenhang kann es sich bei der Probe um ein elektronisches Bauteil handeln oder ein Zwischenprodukt für die Herstellung von elektronischen Bauteilen, beispielsweise einen prozessierten oder teilprozessierten (teilweise bearbeiteten) Wafer.

Die Erfindung umfasst weiterhin auch eine Vorrichtung zur Durchführung des Verfahrens, die dadurch gekennzeichnet ist, dass sie folgende Bestandteile umfasst:

a) eine Messelektrode **1**, die reversibel kontaktierbar ist mit der zu messenden Probe oder einem Probenhalter,

b) eine elektrische Ableitung der Messelektrode **1** zu dem Massepotenzial,

c) eine Vorrichtung zur Messung des elektrischen Stromes, der von der Messelektrode **1** zum Massepotenzial abfließt,

d) eine Gegenelektrode **2**, die beabstandet ist von einer Oberfläche der zu messenden Probe, an die ein bekanntes positives oder negatives elektrisches Potenzial gegenüber dem Massepotenzial anlegbar ist,

e) eine Vorrichtung zur Erzeugung eines Plasmas in der Nähe oder an derjenigen Oberfläche der Probe, von der beabstandet sich die Gegenelektrode **2** befindet, so dass sich das Plasma beim Betrieb der Vorrichtung zwischen der zu messenden Probe und der Gegenelektrode **2** befindet, und

f) eine Auswerteeinheit, die es gestattet, aus dem an der Gegenelektrode **2** angelegten Potenzial $U_1$ über die Beziehung

$$\varphi_{OF} = U_1 \cdot K_{CAIT}$$

das Potenzial $\varphi_{OF}$ an der Probenoberfläche zu bestimmen, die bereichsweise mit dem Plasma in Berührung gebracht ist, wobei es sich bei dem Kalibrierfaktor $K_{CAIT}$ um einen experimentell bestimmten Kalibrierfaktor handelt.

In einer anderen vorteilhaften Ausgestaltung weist die Vorrichtung zur Durchführung des Verfahrens in Erweiterung des vorstehenden Merkmals a) mehrere Messelektroden **1** auf. Jede dieser Messelektroden **1** ist dabei - unabhängig von jeder anderen Messelektrode **1** - reversibel oder irreversibel kontaktierbar mit der zu messenden Probe oder mit mindestens einem Probenhalter. Auch wenn gemäß weiter oben stehendem Merkmal a) nur eine Messelektrode **1** vorgesehen ist, kann diese ebenfalls alternativ irreversibel mit der zu messenden Probe oder einem Probenhalter kontaktierbar sein.

Dass die mindestens eine Messelektrode **1** reversibel oder irreversibel mit der zu messenden Probe oder dem Probenhalter kontaktierbar ist (Merkmal a), s.o.), ist wichtig für den flexiblen Einsatz des Verfahrens bzw. der Vorrichtung. Beispielsweise können mit dem erfindungsgemäßen Verfahren im Zuge der Herstellung von elektronischen Bauteilen wie etwa Transistoren oder integrierten Schaltkreisen die Leitfähigkeiten von nacheinander auf dem Wafer aufzubringenden Schichten zwischen den einzelnen Prozeßschritten gemessen werden, was die Produktionssicherheit und Produktqualität deutlich verbessert. Dafür ist es zum Beispiel unter Umständen erforderlich, bereits am Wafer angebrachte Kontaktpins als jeweils eine irreversibel mit der zu messenden Probe kontaktierte Messelektrode **1** vorzusehen, da der betreffende Kontaktpin möglicherweise im Endprodukt verbleibt. In diesem Zusammenhang sind dann ggf. auch eine oder mehrere zuvor abgeschiedene Schichten, die u. U. ursprünglich eine zu messende Probe waren, einzeln oder gemeinsam nun als Probenhalter anzusehen, die ihrerseits mit der Messelektrode **1** und/oder untereinander sowie gegebenenfalls mit der jetzt zu messenden Probe irreversibel verbunden sind.

Das erfindungsgemäße Verfahren ist in der gegenwärtigen Ausgestaltung besonders geeignet, jedoch nicht beschränkt, auf bzw. für die Messung von geringen Leitfähigkeits- bzw. hohen Widerstandswerten im Bereich von bis zu ca. 100 GΩ (entsprechend ca. $10^{-11}$ S (10 pS)).

Aus dem vorstehend Gesagten geht hervor, dass das erfindungsgemäße Verfahren bzw. die erfindungsgemäße Vorrichtung beispielsweise auch sehr vorteilhaft in der Materialprüfung von Bauteilen eingesetzt werden kann, deren Funktion die elektrische Isolation ist. Derartige Bauteile kommen in sehr vielen Mikrochips, in Batterien und in Brennstoffzellen vor. Dort führen Defekte, z.B. in Form von Rissen oder mikroskopisch kleinen Löchern, zu lokalen elektrischen Kurzschlüssen. Um Folgeschäden zu vermeiden, ist die frühzeitige Identifikation entsprechender Probleme sehr wichtig. Bekannte klassische Verfahren zur Identifikation elektrischer Kurzschlüsse benötigen wieder zwei oder mehr Elektroden in Kontakt mit dem zu testenden Bauteil. Das hier offenbarte Verfahren ermöglicht die rechtzeitige Identifikation von Defekten, die z. B. zu elektrischen Kurzschlüssen führen können, mit weniger Elektrodenkontakten als klassisch benötigt (z. B. bei einer Qualitätskontrolle in einem Herstellungsprozess).

**Ausführungsbeispiele**

Nachfolgend wird das erfindungsgemäße Verfahren anhand einiger beispielhafter Ausführungsbeispiele näher beschrieben, ohne dass damit eine Beschränkung auf die gezeigten Ausführungsbeispiele verbunden ist. Insbesondere gilt dies für die Art von Proben (Material, Form), die mit dem erfindungsgemäßen Verfahren gemessen werden können sowie für die Absolutdrucke bei denen das Verfahren angewendet werden kann. Das Verfahren kann grundsätzlich bei allen Drucken angewendet werden, bei denen in der betreffenden Gasatmosphäre ein stabiles Plasma erzeugt werden kann, unabhängig von der Art der Plasmaerzeugung. Neben den beispielhaft gezeigten Messungen an Gläsern sowie einer Probe yttriumstabilisierten Zirkonoxids können dies dünne Schichten oder kompakte Proben fester oder flüssiger, organischer oder anorganischer Materialien sein. Weitere Ausgestaltungen, die der Fachmann aufgrund allgemein üblicher Vorgehensweise und ohne erfinderische Tätigkeit erarbeitet, fallen somit ebenfalls in den Umfang der Erfindung sowie ihrer Äquivalente. Weiterhin umfassen beispielsweise auch Bereichsangaben stets alle - nicht genannten - Zwischenwerte sowie alle denkbaren Teilintervalle. Die nachfolgenden Ausführungsbeispiele wurden beispielhaft unter Verwendung eines Lasersystems als Vorrichtung zur Erzeugung des Plasmas erarbeitet.

Von einem kommerziell erhältlichen Lasersystem der Fa. KM Labs werden Pulse auf der fs-Zeitskala emittiert. Eine Charakterisierung der Pulse erfolgt im Bedarfsfalle ex situ mit Hilfe eines Spektrometers des Typs S150 der Fa. Solar LaserSystems und eines GRENOUILLE-8-20-USB der Fa. Swamp Optics. Die Pulse können direkt zum Plasma-CAIT-Aufbau geleitet oder zusätzlich durch eine fokussierende Teleskoplinse oder ein anderes geeignetes Mittel zur Fokussierung elektromagnetischer Strahlung geführt werden. Bei Durchführung von CAIT-Experimenten werden emittierte Laserpulse vorteilhafterweise mit Hilfe einer Linse fokussiert, sodass ein Luftplasma in der Nähe bzw. an der Probenoberfläche entsteht. Sofern nicht anders angegeben, wird das Lasersystem bei der höchstmöglichen Leistung betrieben. Diese beträgt im Normalfall zwischen 9.5 W und 10 W.

Auf eine Ionenführung (Ionenoptik) wurde bei Erarbeitung der Ausführungsbeispiele 1 bis 5 verzichtet. Es ist jedoch naheliegend und fällt daher in den Umfang der Erfindung, eine solche vorzusehen, um die räumliche Ausdehnung des Plasmas definierter einzustellen.

Der zu messende Strom (Messstrom) wird mit Hilfe von Transimperdanzverstärkern verstärkt und gemessen sowie anschließend beispielsweise mit USB Modulen aufgezeichnet. Verfahren zur Kalibration beider (Transimpedanzverstärker und USB Modul) sind dem Fachmann aus dem Stand der Technik bekannt und werden verwendet ohne damit den Umfang der Erfindung sowie ihrer Äquivalente zu verlassen. Beispielhaft werden nachfolgend die Messergebnisse von drei Proben beschrieben. Eine dieser Proben, die yttriumdotierte Zirkoniumoxidkeramik, wurde dazu eigens hergestellt, bei den anderen Proben handelt es sich um käufliche Proben. Zur Charakterisierung der selbst synthetisierten Probe wurde eine Dichtemessung durchgeführt.

Für die Erzeugung der Potenziale werden ein Hochspannungsnetzgerät der Fa. Ortec, Typ EG& g (0 bis ±3000 V) und zwei Netzgeräte der Fa. Delta Electronics (0 bis ±300 V) verwendet. Zur Digitalisierung der Messwerte wird ein USB-Modul des Typs ANI 1208 der Fa. National Instruments verwendet. Gemessene Ströme werden mit einem individuell entwickelten LabView-Programm angezeigt. Es erfolgt hierbei auch eine Mittelwertbildung aus den letzten 300 Messwerten. Konstant erscheinende Messwerte werden ggf. auch manuell notiert.

Die weiter unten beschriebenen Ausführungsbeispiele des erfindungsgemäßen Verfahrens wurden unter Verwendung des Aufbaus gemäß Fig. 2 erarbeitet. Im unteren Teil befindet sich ein beheizbarer Probenhalter **7.** Das eigentliche Heizelement befindet sich in einer ausgehöhlten Edelstahlform, der Heizung **10,** und beruht auf dem Prinzip einer Widerstandsheizung. Es besteht aus einem gewickelten Kanthal A-Draht, welcher in eine isolierende Schicht aus *Ceramabond 569* (60% $Al_2O_3$, 40% $K_2SiO_4$) gegossen ist. Hierüber befindet sich ein Korundblock **9.** Dieser besitzt einerseits eine hohe Wärmekapazität und eine schlechte Wärmeleitfähigkeit, wodurch eine konstante Probentemperatur erzielt wird. Andererseits dient er auch zur elektrischen Isolierung zwischen Heizung **10** und dem folgenden Kupferblock, an dem die Stromdetektion erfolgt (entspricht der Messelektrode **1** in Fig. 1A u. Fig. 2). Innerhalb des Kupferblocks (Messelektrode **1**) ist zudem ein Pt100-Widerstandsthermometer **8** eingebaut. Die Temperaturregelung erfolgt mit einem selbstgebauten Regelelement. Dieses beinhaltet ein Netzgerät zur Generierung der Heizleistung und einen PID-Regler zur Temperatursteuerung. Die Probe selbst ist auf einem Probenträger (Probenhalterung) **7** aus Kupfer angebracht, welcher an den Kupferblock (Messelektrode **1**) geschraubt wird. Zwischen Heizung und Probenträger **7** wird zwischen allen Elementen *Heat-Away 641-EV* Wärmeleitpaste angebracht. Die bombardierte Fläche wird von einer 1 mm dicken geerdeten Edelstahlmaske (Maske **4**) mit einer durchlässigen Fläche, beispielsweise in Form einer Öffnung, von 8 mm Durchmesser definiert. Die Geometrie dieser durchlässigen Fläche in der Maske **4** unterliegt keinen Einschränkungen; sie kann im wesentlichen kreisförmig, quadratisch, rechteckig, trapezförmig, dreieckig oder gänzlich irregulär gestaltet sein. Bei einigen Ausführungsbeispielen wird zwischen Probe und Edelstahlmaske **4** eine weitere 0.45 mm dicke Teflonmaske **12** angebracht (vgl. Fig. 1B). Neben Teflon können natürlich auch andere nichtleitende Materialien, insbesondere andere Polymere (PE, PP, PVC, PC, PMMA, Polyester usw.) oder Keramiken als zusätzliche Maske **12** verwendet werden ohne den Umfang der Erfindung sowie ihrer Äquivalente zu verlassen. Das Plasma wird zwischen Maske und Gegenelektrode generiert. Auftretende Rückseitenströme werden von dem im Folgeabsatz beschriebenen Transimpedanzverstärker verstärkt. Detektion und Digitalisierung erfolgen mittels eines *USB 231* Moduls von *Measurement Computing.*

Mit dem eigens für dieses Verfahren konzipierten und gebauten Transimpedanzverstärkers ist es möglich, gleichzeitig Ströme vom pA- bis zum mA-Bereich in Spannungen einer leicht messbaren Größenordnung zu wandeln und ein definiertes, von der elektronischen Masse (Erdung) abweichendes Potenzial an die Rückseite der zu messenden Probe anzulegen.

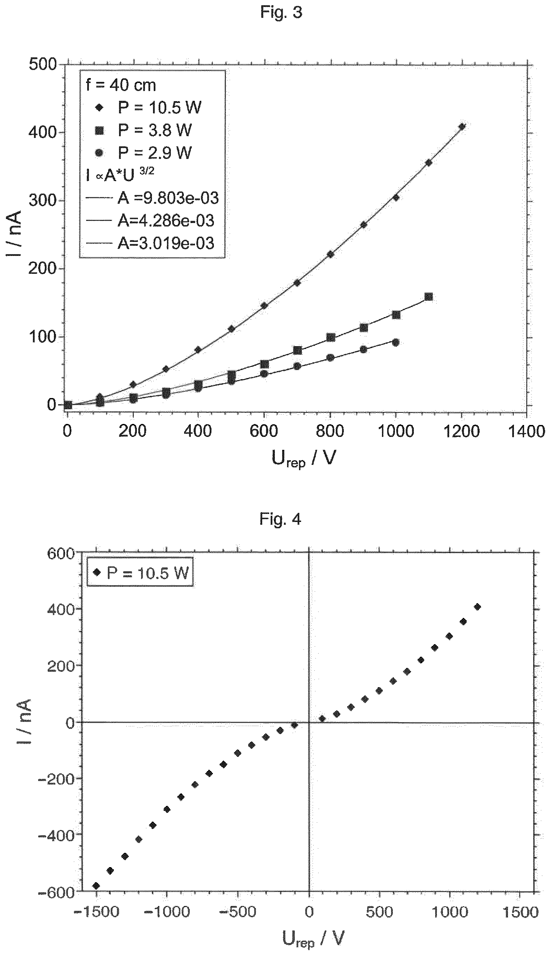

Zunächst erfolgt eine Charakterisierung der Vorrichtung/des Meßaufbaus durch Messung des Blindstromes, d.h. des Stromes, der (bei variablen Potenzialen) durch die Vorrichtung fließt, wenn keine Probe darin befindlich ist. Zunächst werden sowohl an die Gegenelektrode **2,** als auch an die Maske **4** Spannungen angelegt. Die dabei gemessenen Ströme sind in Fig. 3 bei verschiedenen Laserleistungen aufgetragen. Bei den höchsten gewählten Spannungen wird ein Ionenstrom von 400 nA gemessen.

Aus den so erhaltenen Messwerten kann bereits abgeschätzt werden, dass große Teile der erzeugten Ionen vermutlich nicht die Messelektrode **1** erreichen, sondern bereits vorher neutralisiert werden. Gaskinetisch betrachtet, liegt die freie Weglänge eines Teilchens im zweistelligen Nanometerbereich. Viele Richtungs- und Impulsänderungen bewirken so eine starke Aufweitung des Strahls.

Wird für die Charakterisierung des Ionenstroms lediglich eine aus Gegenelektrode und Messelektrode im Abstand von 1.5 cm bestehende Anordnung gewählt, erhält man für die höchste verwendete Laserleistung die in Fig. 4 gezeigten Stromspannungskurven bei Darstellung beider Polaritäten. Bei einer Spannung an der Gegenelektrode von 1200 V kann so ein Ionenstrom von über 400 nA detektiert werden. Die Messwertschwankungen lagen bei der niedrigsten Spannung an der Gegenelektrode in der Nähe der Nachweisgrenze (ca. $\pm 50$ pA) und betragen im Fall der höchsten Spannung an der Gegenelektrode ungefähr $\pm 10$ nA. Die gefundene Abweichung, welche relativ unter 1% beträgt, kann unter anderem auf die leicht schwankende Laserleistung zurückzuführen sein. Es wird somit im Rahmen der Genauigkeit ein stationäres Ionen-Emissionsverhalten aus dem Plasma heraus festgestellt.

Bei dem hier verwendeten Lasersystem wird mit einer Repetitionsrate von 15 kHz gearbeitet. Dies entspricht der Emission von einem Puls alle 66 $\mu$s. Somit treffen auch bei den höchsten im Rahmen der Arbeit verwendeten Feldern von 1200 V/cm mehrere Pulse auf das Plasma, bevor dieses abklingen kann. Dies ist ein weiteres Indiz für die gerechtfertigte Annahme eines stationären Ionen-Emissionsverhaltens aus dem Plasma heraus. Die kurzen Pulse werden im hier beispielhaft beschriebenen Aufbau für die hohen Spitzenintensitäten benötigt. Diese Kombination kurzer Pulse mit sehr hoher Repetitionsrate, ermöglicht eine quasi-kontinuierliche Strommessung. Bei Verwendung eines cw-Lasers mit entsprechend hoher mittlerer Leistung kann dies ebenfalls erreicht werden.

Nachfolgend werden einige Ausführungsbeispiele des erfindungsgemäßen Verfahrens unter Verwendung folgender Materialproben beschrieben:

- Ein D263T®-Glas der Fa. Schott, Mainz; das hier verwendete Glas besitzt eine Dicke von 399 $\mu$m.
- Ein Glas-Labormuster der Zusammensetzung 30 CaO · 25 $Na_2O$ · 45 $P_2O_5$. Das hier verwendete Glas besitzt eine Dicke von 476 $\mu$m.
- Eine yttriumstabilisierte Zirkonoxidkeramik, herge-

stellt aus yttriumdotiertem Zirkoniumoxidpulver (TZ-8Y) der Fa. TOSOH.

Die Herstellung der yttriumdotierten Zirkoniumoxidkeramik erfolgte wie folgt:
Mit einer uniaxialen Presse wurden Presslinge hergestellt und anschließend in einem Hochtemperaturofen des Typs HTL 04/17 der Fa. Thermoconcept getempert (in 4 h auf 1500 °C aufheizen, die Temperatur für 8 h halten und anschließend in 4 h auf Raumtemperatur abkühlen). Es werden gegenüber Wasser, Lösungsmittel und externem Druck stabile Pellets mit deutlich sichtbarer Volumenreduktion erhalten. Mit Hilfe einer Poliermaschine des Typs LaboPol-5 wurden diese zunächst geschliffen und dann mit Diamantpaste verschiedener Feinheitsgrade der Fa. Kemet geschliffen. Die letztendlich verwendete Probe besitzt eine Dicke von 2.355 mm und einen Durchmesser von 10.56 mm.

Ausführungsbeispiel 1 (Kalibrierung des effektiven Oberflächenpotentials):

Die vorstehend beschriebenen Messungen des Blindstroms zeigen bereits eine ausreichend große Ionenemission für CAIT-Messungen unter Normaldruck. Zur Bestimmung von Leitfähigkeiten ist jedoch auch ein definierter Potenzialgradient zwischen Vorder- und Rückseite der Probe und damit die Kenntnis des effektiven Oberflächenpotenzials notwendig.

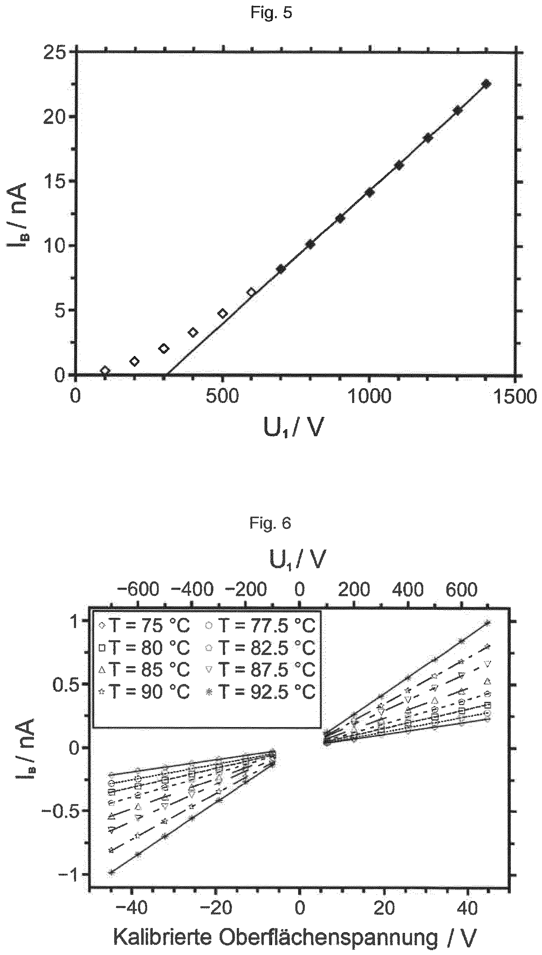

Zur Lösung dieses Problems wird eine zusätzliche 0.45 mm dicke Teflonmaske **12** zwischen der geerdeten Edelstahlmaske **4** und der Probe, beziehungsweise dem leeren Probenträger **7** / Messelektrode **1** angebracht. Im Fall des leeren Probenträgers **7** besteht so eine zur Flächendefinition notwendige, elektrische Isolation zur Maske **4**. In Fig. 6 sind Messungen des Stroms mit einem in Reihe geschalteten 3.11 GΩ-Kalibrier-Widerstand gezeigt.

Für den Blindstrom im Rahmen dieses Ausführungsbeispiels ergibt sich qualitativ ein ähnliches Verhalten wie dem in Fig. 3 gezeigten Verhalten. Aufgrund der nicht planaren Geometrie und dreier beteiligter Bauteile (Gegenelektrode **2**, Maske **4**, Probenhalter **7** bzw. Messelektrode **1**) zeigt der detektierte Strom jedoch keine Abhängigkeit von $(U_1)^{3/2}$.

Bei nachgeschaltetem 3.11 GΩ-Kalibrier-Widerstand wird im Bereich höherer Spannungen an der Gegenelektrode ein lineares Verhalten der detektierten Ströme $I_B$ beobachtet. Aus einer Anpassung an diese Werte kann rein numerisch ein Widerstand von 48.4 GΩ ermittelt werden. Dieser Wert weicht um den Faktor 15.6 vom reellen Widerstand der Probe ab, woraus sich die folgende Kalibrierung des Oberflächenpotentials in Form einer Materialkonstanten gemäß Gleichung 5 bzw. 5.1 ergibt:

$$U_1 = \varphi_{OF} \cdot 15.6 \qquad (Gl. 5)$$

$$\varphi_{OF} = U_1 / 15.6 \qquad (Gl. 5.1).$$

Es ist für den Fachmann offensichtlich, dass der hier ermittelte Kalibrierungsfaktor von 15.6 strenggenommen nur speziell für diesen Aufbau und diese Probe gültig ist. Andere Ausführungsvarianten der erfindungsgemäßen Vorrichtung oder des erfindungsgemäßen Verfahrens, andere Messparameter sowie andere Proben benötigen - je nach gewünschter Messgenauigkeit - individuell ermittelte eigene Kalibrierungsfaktoren. Es fällt daher ebenfalls in den Umfang der Erfindung sowie ihrer Äquivalente, je nach vorliegender Fragestellung (Mess-Aufgabe, gewünschter Genauigkeit usw.) individuelle Kalibrierfaktoren zu ermitteln und zu verwenden.

Mit Hilfe der in diesem Ausführungsbeispiel 1 beschriebenen Kalibrierung können nun absolute Leitfähigkeiten verschiedener Materialproben bestimmt werden.

Ausführungsbeispiel 2 (Leitfähigkeitsmessungen am D263T®-Glas):

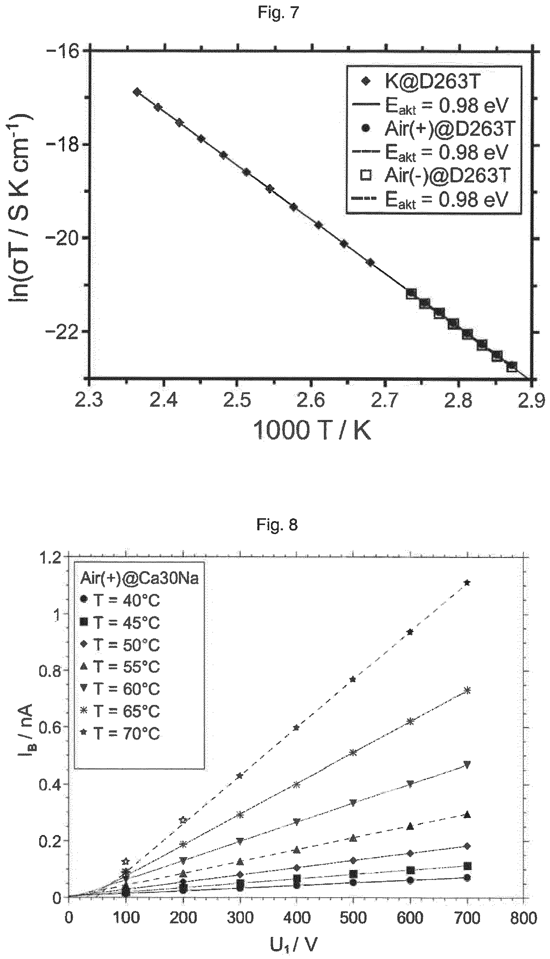

Fig. 8 zeigt Messergebnisse (Strom-Spannungs-Kurven) eines $Ca_{30}Na$-Glases. Fig. 7 zeigt demgegenüber ARRHENIUS-Plots zur Bestimmung der Aktivierungsenergie des D263T®-Glases auf Basis kalibrierter spezifischer Leitfähigkeiten mittels Atmosphärendruck-Plasma-CAIT an Luft und mittels Kaliumbombardement (Vakuum-BIIT). Es handelt sich um Messungen des D263T®-Glases bei Messung mit Teflonmaske **12** für verschiedene Temperaturen und für beide Polaritäten. Im untersuchten Temperaturbereich wird Ohmsches Verhalten beobachtet. Unter Verwendung der vorstehend beschriebenen Kalibrierungsfunktion wird die spezifische Leitfähigkeit (Gl. 5) erhalten. Die Darstellung der spezifischen Leitfähigkeit als Funktion der inversen Temperatur in einer halblogarithmischen Darstellung (Arrhenius Plot) eröffnet Zugang zur Aktivierungsenergie für den Ladungsträgertransport. Hier ergibt sich für beide Polaritäten ein Wert von $E_{akt} = 0.98$ eV. Zusätzlich sind zum Vergleich Ergebnisse aus Vakuum-BIIT-Messungen mit einem $K^+$-Ionenstrahl dargestellt. Die jeweiligen Messungen wurden in einem unterschiedlichen Temperaturbereich durchgeführt, zeigen jedoch eine im Rahmen der Fehlergrenzen von etwa 0.05 eV sehr gute Übereinstimmung.

Ausführungsbeispiel 3 (Messung des $Ca_{30}Na$-Glas):

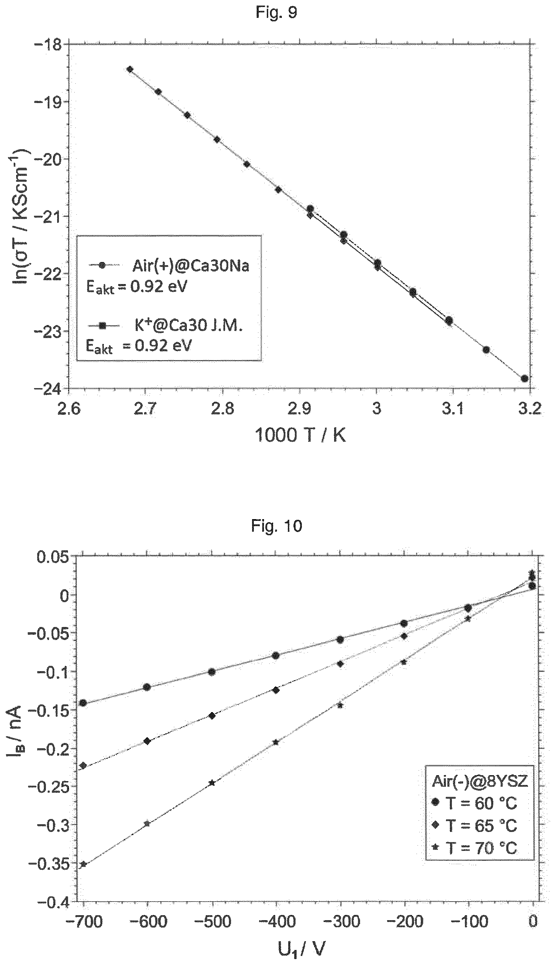

Die bei der Messung des $Ca_{30}Na$-Glases erhaltenen Strom-Spannungs-Kurven sind in Fig. 8 gezeigt. Es wurde bei positiven Spannungen an der Gegenelektrode und Temperaturen im Bereich von 40 °C bis 70 °C gemessen. Bei den Temperaturen 65 °C und 70°C wurden ein, resp. zwei Werte bei geringen Spannungen an der Gegenelektrode für die lineare Anpassung (lineare Regression) nicht berücksichtigt. In Fig. 9 ist unter Verwendung der Kalibrierungsfunktion für die spezifische Leitfähigkeit (Gl. 5) die Aktivierungsenergie des Glases dargestellt (ARRHENIus-Plot). Zum Vergleich sind ebenfalls die Ergebnisse aus einer vorherigen Messung (Vakuum-BIIT, K$^+$) aufgetragen. Es ergibt sich in sehr guter Übereinstimmung mit dem aus der Vakuum-BIIT bekannten Wert der Probe eine Aktivierungsenergie von 0.92 eV.

Ausführungsbeispiel 4 (Messung der 8YSZ-Keramik):

Eine 2.355 mm dicke 8YSZ-Probe wurde für die Messungen verwendet. Für die Charge, aus der diese Probe stammt, wurde mittels Pyknometer eine Dichte von 5.70 g/cm$^3$ bestimmt. Dies bedeutet eine relative Abweichung von 4.2% gegenüber der Herstellerangabe von 5.95 g/cm$^3$. Eine solche Abweichung ist nicht ungewöhnlich und kann beispielsweise auf das lediglich uniaxiale Pressen zurückgeführt werden. Die an dieser Probe gemessenen Strom-Spannungs-Kurven einer Normaldruck-CAIT-Messung sind Fig. 10 dargestellt.

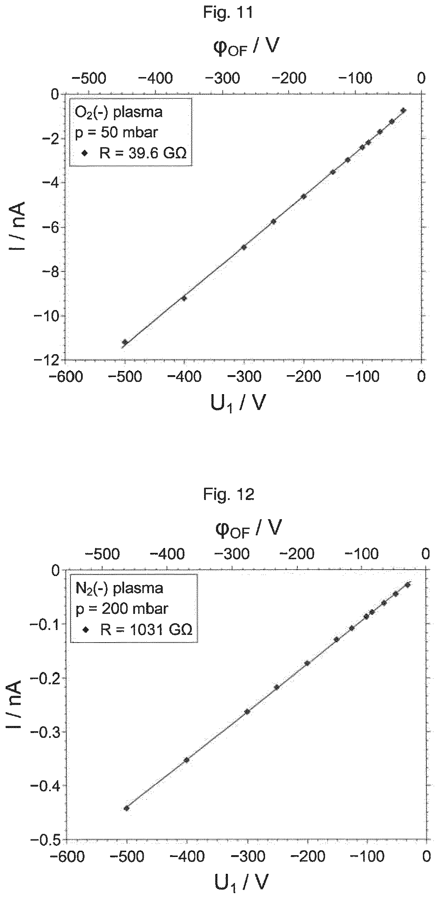

Die Versuchsergebnisse weiterer Ausführungsbeispiele sind in den Figuren 11 bis 13 dargestellt. Sie wurden an kommerziell verfügbaren Referenz-Widerstandselementen durchgeführt und dienen als weitere beispielhafte Belege dafür, dass das hier offenbarte Verfahren der Widerstands- bzw. Leitfähigkeitsmessung auch für andere Gasmedien und für andere Drucke anwendbar ist; sie sind ebenfalls nicht einschränkend zu verstehen. Der Kalibrierungsfaktor für die Umrechnung des sogenannten Repeller-Potentials ($U_1$) in ein effektives Oberflächenpotential ($\varphi_{OF}$), beträgt für die nachfolgenden Ausführungsbeispiele jeweils ca. 1.09, gemäß Gleichung 6:

$$\varphi_{OF} = U_1/1.09 \qquad \text{Gl. 6}$$

Ausführungsbeispiel 5 (Fig. 11) zeigt gemessene Strom-Spannungs-Daten für den Fall, dass ein Sauerstoffplasma bei einem Druck von 50 mbar in negativer Polarität verwendet wurde. Aus der Steigung der Strom-Spannungs-Daten ergibt sich der korrekte (also der dem bekannten Referenzwert entsprechende) Widerstand von 39.6 GΩ.

Ausführungsbeispiel 6 (Fig. 12) zeigt gemessene Strom-Spannungs-Daten für den Fall, dass ein Stickstoffplasma bei einem Druck von 200 mbar in negativer Polarität verwendet wurde. Aus der Steigung der Strom-Spannungs-Daten ergibt sich der korrekte (also der dem bekannten Referenzwert entsprechende) Widerstand von 1031 GΩ

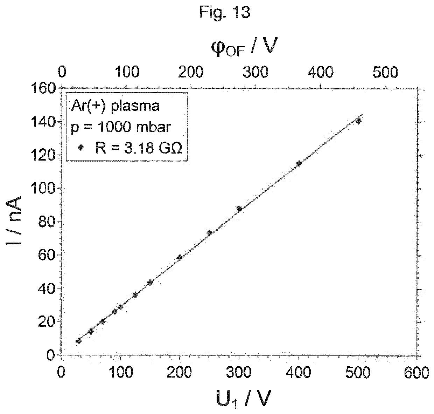

Ausführungsbeispiel 7 (Fig. 13) zeigt gemessene Strom-Spannungs-Daten für den Fall, daß ein Argonplasma bei einem Druck von 1000 mbar in positiver Polarität verwendet wurde. Aus der Steigung der Strom-Spannungs-Daten ergibt sich der korrekte (also der dem bekannten Referenzwert entsprechende) Widerstand von 3.18 GΩ.

## Bezugszeichenliste

| | |
|---|---|
| 1 | Messelektrode |
| 2 | Gegenelektrode |
| 3 | Plasma |
| 4 | Maske, elektrisch leitfähig, z. B. Edelstahl |
| 5 | Gestänge |
| 6 | Isolationselemente |
| 7 | Probenhalter/Probenaufnahme/Probenträger |
| 8 | Pt100-Widerstandsthermometer |
| 9 | Korundblock |
| 10 | Heizung |
| 11 | Grundplatte |
| 12 | Maske, elektrisch nichtleitend, z. B. Teflon |
| 13 | Lasersystem |
| 14 | Datenauswertung |
| 15 | Umlenkspiegel |
| 16 | Linse |
| 17 | Laserstrahl |

## Abbildungslegenden

Fig. 1A: Schematische Darstellung des grundsätzlichen Aufbaus der erfindungsgemäßen Vorrichtung. Beispielhaft schematisch dargestellt ist hierbei eine Verfahrensvariante, bei der die Gegenelektrode 2 positiv gegenüber dem Massepotenzial aufgeladen ist, so dass sich die anionischen Ladungsträger (symbolisiert durch Minuszeichen) zur Gegenelektrode 2 hin bewegen und die kationischen Ladungsträger (symbolisiert durch Pluszeichen) zur Probenoberfläche hin. Von letzteren sind schematisch nur diejenigen symbolisiert, die die Probenoberfläche erreichen.

Fig. 1B: Schematische Darstellung eines Aufbaus der erfindungsgemäßen Vorrichtung mit weiteren peripheren Bauteilen, z.B. einem Lasersystem 13 zur Erzeugung des Plasmas.

Fig. 2: Schematische, nicht maßstabsgetreue Zeichnung einer weiteren Ausführungsform der erfindungsgemäßen Vorrichtung.

Fig. 3: Ionenströme ohne Ionenoptik, d.h. ohne zusätzlicher Elektrode(n) zwischen Gegenelektrode **2** und Maske **4,** in Abhängigkeit von der Spannung an der Gegenelektrode **2** und der Laserleistung.

Fig. 4: Detektierte Ionenströme aus der Plasmaemission bei beiden Polaritäten.

Fig. 5: Detektierter Strom an Probenträger mit nachgeschaltetem 3.11 GΩ-Widerstand.

Fig. 6:    Strom-Spannungs-Kurven der Messungen an einem D263T®-Glas mit negativen Spannungen an der Gegenelektrode **2.**

Fig. 7:    Vergleich von ARRHENIUS-Plots zur Bestimmung der Aktivierungsenergie des D263T®-Glases auf Basis kalibrierter spezifischer Leitfähigkeiten mittels Atmosphärendruck-Plasma-CAIT und mittels Kaliumbombardement (Vakuum-BIIT).

Fig. 8:    Normaldruck-Plasma-CAIT mit positiven Ladungsträgern: Erhaltene Strom-Spannungs-Kurven eines Ca$_{30}$Na-Glases.

Fig. 9:    Vergleich von ARRHENIUS-Plots auf Basis kalibrierter spezifischer Leitfähigkeiten sowie mittels Kaliumbombardement (Vakuum-BIIT) an einem Ca$_{30}$Na-Glas.

Fig. 10:    Normaldruck-Plasma-CAIT mit negativen Ladungsträgern an 8YSZ: Strom-Spannungs-Charakteristik.

Fig. 11:    Messergebnisse (graphische Darstellung) von Ausführungsbeispiel 5 (Sauerstoff plasma bei ca. 50 mbar).

Fig. 12:    Messergebnisse (graphische Darstellung) von Ausführungsbeispiel 6 (Stickstoffplasma bei ca. 200 mbar.

Fig. 13:    Messergebnisse (graphische Darstellung) von Ausführungsbeispiel 7 (Argonplasma bei ca. 1000 mbar.

**Patentansprüche**

1.    Verfahren zur Bestimmung der elektrischen Leitfähigkeit eines festen oder flüssigen Materials, wobei die Probe des Materials, an der die elektrische Leitfähigkeit gemessen wird, an einer ersten Stelle punktuell oder bereichsweise mit mindestens einer Messelektrode elektrisch leitend kontaktiert wird, und an einer zweiten Stelle bereichsweise mit einem Plasma in Berührung gebracht wird, so dass die Probe durch das Plasma definiert elektrisch aufgeladen wird, und die elektrische Aufladung der Probe über die mindestens eine Messelektrode abgeleitet wird, wobei die Strommessung an der mindestens einen Messelektrode erfolgt, und die Bestimmung der Messspannung durch Berechnung des bestehenden Spannungsabfalls über die Probe aus der Quellspannung des Plasmas erfolgt.

2.    Verfahren gemäß Anspruch 1, **dadurch gekennzeichnet, dass** die Kontaktierung an der ersten Stelle der Probe des Materials, an der die elektrische Leitfähigkeit gemessen wird, reversibel erfolgt.

3.    Verfahren gemäß Anspruch 1, **dadurch gekennzeichnet, dass** die Kontaktierung an der ersten Stelle der Probe des Materials, an der die elektrische Leitfähigkeit gemessen wird, irreversibel erfolgt.

4.    Verfahren gemäß einem der vorhergehenden Ansprüche, **dadurch gekennzeichnet, dass** die Kontaktierung an der ersten Stelle der Probe des Materials, an der die elektrische Leitfähigkeit gemessen wird, indirekt über mindestens einen Probenhalter erfolgt.

5.    Verfahren gemäß einem der vorhergehenden Ansprüche, **dadurch gekennzeichnet, dass** es bei einem Absolutdruck von 10$^{11}$ Pa bis 0.1 Pa durchgeführt wird.

6.    Verfahren gemäß einem der vorhergehenden Ansprüche, **dadurch gekennzeichnet, dass** es sich bei dem verwendeten Plasma um ein Atmosphärendruck-Plasma handelt.

7.    Verfahren gemäß einem der vorhergehenden Ansprüche, **dadurch gekennzeichnet, dass** das Plasma in Umgebungsluft oder in einer Gasmischung, die die Zusammensetzung von Umgebungsluft aufweist, erzeugt wird.

8.    Verfahren gemäß einem der vorhergehenden Ansprüche 1 bis 3, **dadurch gekennzeichnet, dass** es in einer Gasmischung durchgeführt wird, deren Zusammensetzung sich von der Zusammensetzung der natürlichen Atmosphäre unterscheidet.

9.    Verfahren gemäß einem der vorhergehenden Ansprüche, **dadurch gekennzeichnet, dass** das Plasma erzeugt wird mit Hilfe von Lasern, Mikrowellen, Hochfrequenzspannung, Trioden-Anordnungen.

10.    Verfahren gemäß einem der vorhergehenden Ansprüche, **dadurch gekennzeichnet, dass** es sich bei dem festen oder flüssigen Material um eine Oberflächenschicht handelt.

11.    Verwendung des Verfahrens gemäß einem der vorhergehenden Ansprüche zur Bestimmung des Widerstandes oder der Leitfähigkeit einer Oberfläche.

12.    Verwendung des Verfahrens gemäß einem der vorhergehenden Ansprüche 1 bis 10 zur Bestimmung des Volumen-Widerstandes oder der Volumen-Leitfähigkeit einer Probe oder eines Teils einer Probe.

13.    Vorrichtung zur Durchführung des Verfahrens gemäß einem der vorhergehenden Ansprüche 1 bis 10, **dadurch gekennzeichnet, dass** die Vorrichtung folgende Bestandteile umfasst:

   a) eine Messelektrode (**1**), die reversibel kontaktierbar ist mit der zu messenden Probe,
   b) eine elektrische Ableitung der Messelektrode (**1**) zu dem Massepotenzial, wobei es sich bei dem Massepotential um das Potential handelt, das durch Potentialausgleich gegenüber Erde, d.h. durch "Erdung", erreicht wird,

c) eine Vorrichtung zur Messung des elektrischen Stromes, der von der Messelektrode (**1**) zum Massepotenzial abfließt,

d) eine Gegenelektrode (**2**), die beabstandet ist von einer Oberfläche der zu messenden Probe, an die ein bekanntes positives oder negatives elektrisches Potenzial gegenüber dem Massepotenzial anlegbar ist,

e) eine Vorrichtung zur Erzeugung eines Plasmas in der Nähe oder an derjenigen Oberfläche der Probe, von der beabstandet sich die Gegenelektrode (**2**) befindet, so dass sich das Plasma beim Betrieb der Vorrichtung zwischen der zu messenden Probe und der Gegenelektrode (**2**) befindet, und

f) eine Auswerteeinheit, die es gestattet, aus dem an der Gegenelektrode (**2**) angelegten Potenzial $U_1$ über die Beziehung

$$\varphi_{OF} = U_1 \cdot K_{CAIT}$$

das Potenzial $\varphi_{OF}$ an der Probenoberfläche zu bestimmen, die bereichsweise mit dem Plasma in Berührung gebracht ist, wobei es sich bei dem Kalibrierfaktor $K_{CAIT}$ um einen experimentell bestimmten Kalibrierfaktor handelt.

14. Vorrichtung zur Durchführung des Verfahrens gemäß einem der vorhergehenden Ansprüche 1 bis 10, **dadurch gekennzeichnet, dass** die Vorrichtung folgende Bestandteile umfasst:

a) eine Messelektrode (**1**), die irreversibel kontaktierbar ist mit der zu messenden Probe,

b) eine elektrische Ableitung der Messelektrode (**1**) zu dem Massepotenzial, wobei es sich bei dem Massepotential um das Potential handelt, das durch Potentialausgleich gegenüber Erde, d.h. durch "Erdung", erreicht wird,

c) eine Vorrichtung zur Messung des elektrischen Stromes, der von der Messelektrode (**1**) zum Massepotenzial abfließt,

d) eine Gegenelektrode (**2**), die beabstandet ist von einer Oberfläche der zu messenden Probe, an die ein bekanntes positives oder negatives elektrisches Potenzial gegenüber dem Massepotenzial anlegbar ist,

e) eine Vorrichtung zur Erzeugung eines Plasmas in der Nähe oder an derjenigen Oberfläche der Probe, von der beabstandet sich die Gegenelektrode (**2**) befindet, so dass sich das Plasma beim Betrieb der Vorrichtung zwischen der zu messenden Probe und der Gegenelektrode (**2**) befindet, und

f) eine Auswerteeinheit, die es gestattet, aus dem an der Gegenelektrode (**2**) angelegten Potenzial $U_1$ über die Beziehung

$$\varphi_{OF} = U_1 \cdot K_{CAIT}$$

das Potenzial $\varphi_{OF}$ an der Probenoberfläche zu bestimmen, die bereichsweise mit dem Plasma in Berührung gebracht ist, wobei es sich bei dem Kalibrierfaktor $K_{CAIT}$ um einen experimentell bestimmten Kalibrierfaktor handelt.

**Claims**

1. Method for determining the electrical conductivity of a solid or liquid material, wherein the sample of the material, at which the electrical conductivity is measured, is contacted at a first point or at a first region in an electrically conductive manner with at least one measuring electrode, and is brought into contact with a plasma at a second region, so that the sample is electrically charged in a defined manner by the plasma, and the electrical charge of the sample is discharged via the at least one measuring electrode, the current being measured at the at least one measuring electrode, and the measurement voltage being determined by calculating the existing voltage drop across the sample from the source voltage of the plasma.

2. The method according to claim 1, **characterised in that** the contacting is reversible at the first location of the sample of the material at which the electrical conductivity is measured.

3. The method according to claim 1, **characterised in that** the contacting is irreversible at the first location of the sample of the material at which the electrical conductivity is measured.

4. Method according to one of the preceding claims, **characterized in that** the contacting at the first location of the sample of the material, at which the electrical conductivity is measured, is carried out indirectly via at least one sample holder.

5. A method according to any one of the preceding claims, **characterised in that** it is carried out at an absolute pressure of $10^{11}$ Pa to 0.1 Pa.

6. A method according to any one of the preceding claims, **characterised in that** the plasma used is an atmospheric pressure plasma.

7. A method according to any one of the preceding claims, **characterised in that** the plasma is generated in ambient air or in a gas mixture having the composition of ambient air.

8. Method according to any one of the preceding claims 1 to 3, **characterized in that** it is carried out in a gas mixture whose composition is different from the composition of the natural atmosphere.

9. Method according to any one of the preceding claims, **characterized in that** the plasma is generated by means of lasers, microwaves, high frequency voltage, triode arrays.

10. A method according to any one of the preceding claims, **characterised in that** the solid or liquid material is a surface layer.

11. Use of the method according to any one of the preceding claims for determining the resistance or conductivity of a surface.

12. Use of the method according to any one of the preceding claims 1 to 10 for determining the volume resistivity or volume conductivity of a sample or part of a sample.

13. Device for carrying out the method according to one of the preceding claims 1 to 10, **characterised in that** the device comprises the following components:

   a) a measuring electrode (**1**) which can be reversibly contacted with the sample to be measured,
   b) an electrical discharge of the measuring electrode (**1**) to the earth potential, the earth potential being the potential achieved by potential equalisation with respect to earth, i.e. by "earthing",
   c) a device for measuring the electric current flowing from the measuring electrode (**1**) to the earth potential,
   d) a counter electrode (**2**) which can be reversibly contacted with the sample to be measured. by "earthing",
   c) a device for measuring the electric current flowing from the measuring electrode (**1**) to the earth potential,
   d) a counter electrode (**2**) spaced from a surface of the sample to be measured, to which a known positive or negative electric potential can be applied with respect to the earth potential,
   e) a device for generating a plasma in the vicinity of or on that surface of the sample from which the counter-electrode (**2**) is spaced apart, so that the plasma is located between the sample to be measured and the counter-electrode (**2**) during operation of the device, and
   f) an evaluation unit which makes it possible to determine from the potential $U_1$ applied to the counter-electrode (**2**) via the relationship

$$\varphi_{OF} = U_1 \cdot K_{CAIT}$$

to determine the potential $\varphi_{OF}$ at the sample surface which is brought into contact with the plasma in certain areas, the calibration factor $K_{CAIT}$ being an experimentally determined calibration factor.

14. Device for carrying out the method according to one of the preceding claims 1 to 10, **characterised in that** the device comprises the following components:

   a) a measuring electrode (**1**) which can be irreversibly contacted with the sample to be measured,
   b) an electrical discharge of the measuring electrode (**1**) to the earth potential, the earth potential being the potential achieved by potential equalisation with respect to earth, i.e. by "earthing",
   c) a device for measuring the electric current flowing from the measuring electrode (**1**) to the earth potential,
   d) a counter electrode (**2**) which can be reversibly contacted with the sample to be measured. by "earthing",
   c) a device for measuring the electric current flowing from the measuring electrode (**1**) to the earth potential,
   d) a counter electrode (**2**) spaced from a surface of the sample to be measured, to which a known positive or negative electric potential can be applied with respect to the earth potential,
   e) a device for generating a plasma in the vicinity of or on that surface of the sample from which the counter-electrode (**2**) is spaced apart, so that the plasma is located between the sample to be measured and the counter-electrode (**2**) during operation of the device, and
   f) an evaluation unit which makes it possible to determine from the potential $U_1$ applied to the counter-electrode (**2**) via the relationship

$$\varphi_{OF} = U_1 \cdot K_{CAIT}$$

to determine the potential $\varphi_{OF}$ at the sample surface which is brought into contact with the plasma in certain areas, the calibration factor $K_{CAIT}$ being an experimentally determined calibration factor.

**Revendications**

1. Procédé de détermination de la conductivité électrique d'un matériau solide ou liquide, dans lequel l'échantillon du matériau sur lequel la conductivité électrique est mesurée est mis en contact électriquement conducteur avec au moins une électrode de mesure à un premier endroit ou par zones, et est mis en contact avec un plasma à un deuxième endroit par zones, de sorte que l'échantillon est chargé électriquement de manière définie par le plasma, et la charge électrique de l'échantillon est dérivée par l'intermédiaire de l'au moins une électrode de mesure, la mesure du courant s'effectuant sur l'au moins une électrode de mesure, et la détermination de la tension de mesure s'effectuant par calcul de la chute de tension existante sur l'échantillon à partir de la tension source du plasma.

2. Procédé selon la revendication 1, **caractérisé en ce que** la mise en contact est réversible au premier endroit de l'échantillon du matériau où la conductivité électrique est mesurée.

3. Procédé selon la revendication 1, **caractérisé en ce que** la mise en contact est irréversible au premier endroit de l'échantillon du matériau où la conductivité électrique est mesurée.

4. Procédé selon l'une quelconque des revendications précédentes, **caractérisé en ce que** la mise en contact au premier endroit de l'échantillon du matériau où la conductivité électrique est mesurée est réalisée indirectement par au moins un porte-échantillon.

5. Procédé selon l'une des revendications précédentes, **caractérisé en ce qu'**il est réalisé à une pression absolue comprise entre $10^{11}$ Pa et 0,1 Pa.

6. Procédé selon l'une quelconque des revendications précédentes, **caractérisé en ce que** le plasma utilisé est un plasma à pression atmosphérique.

7. Procédé selon l'une quelconque des revendications précédentes, **caractérisé en ce que** le plasma est généré dans l'air ambiant ou dans un mélange de gaz ayant la composition de l'air ambiant.

8. Procédé selon l'une quelconque des revendications précédentes 1 à 3, **caractérisé en ce qu'**il est mis en œuvre dans un mélange gazeux dont la composition est différente de la composition de l'atmosphère naturelle.

9. Procédé selon l'une quelconque des revendications précédentes, **caractérisé en ce que** le plasma est généré à l'aide de lasers, de micro-ondes, de tensions à haute fréquence, d'ensembles triodes.

10. Procédé selon l'une quelconque des revendications précédentes, **caractérisé en ce que** le matériau solide ou liquide est une couche de surface.

11. Utilisation du procédé selon l'une quelconque des revendications précédentes pour déterminer la résistivité ou la conductivité d'une surface.

12. Utilisation du procédé selon l'une quelconque des revendications précédentes 1 à 10 pour déterminer la résistivité volumique ou la conductivité volumique d'un échantillon ou d'une partie d'échantillon.

13. Dispositif pour la mise en oeuvre du procédé selon l'une des revendications précédentes 1 à 10, **caractérisé en ce que** le dispositif comprend les éléments suivants:

   a) une électrode de mesure (**1**) qui peut être mise en contact de manière réversible avec l'échantillon à mesurer,
   b) une dérivation électrique de l'électrode de mesure (**1**) vers le potentiel de masse, le potentiel de masse étant le potentiel obtenu par compensation de potentiel par rapport à la terre, c'est-à-dire "potentiel de terre",
   c) un dispositif de mesure du courant électrique qui s'écoule de l'électrode de mesure (**1**) vers le potentiel de masse,
   d) une contre-électrode (**2**), qui est espacée d'une surface de l'échantillon à mesurer, à laquelle peut être appliqué un potentiel électrique positif ou négatif connu par rapport au potentiel de masse,
   e) un dispositif de production d'un plasma à proximité ou sur la surface de l'échantillon dont la contre-électrode (**2**) est éloignée, de sorte que le plasma se trouve entre l'échantillon à mesurer et la contre-électrode (**2**) lors du fonctionnement du dispositif, et
   f) une unité d'évaluation qui permet, à partir du potentiel $U_1$ appliqué à la contre-électrode (**2**), de déterminer la valeur de la relation

$$\varphi_{OF} = U_1 \cdot K_{CAIT}$$

   de déterminer le potentiel $\varphi_{OF}$ à la surface de l'échantillon qui est mis en contact par zones avec le plasma, le facteur d'étalonnage $K_{CAIT}$ étant un facteur d'étalonnage déterminé expérimentalement.

14. Dispositif pour la mise en oeuvre du procédé selon l'une des revendications précédentes 1 à 10, **caractérisé en ce que** le dispositif comprend les éléments suivants :

   a) une électrode de mesure (**1**) qui peut être mise en contact de manière irréversible avec l'échantillon à mesurer,
   b) une dérivation électrique de l'électrode de mesure (**1**) vers le potentiel de masse, le potentiel de masse étant le potentiel qui est atteint par compensation de potentiel par rapport à la terre, c'est-à-dire par "mise à la terre",

c) un dispositif de mesure du courant électrique qui s'écoule de l'électrode de mesure (**1**) vers le potentiel de masse,

d) une contre-électrode (**2**) qui est espacée d'une surface de l'échantillon à mesurer et à laquelle peut être appliqué un potentiel électrique positif ou négatif connu par rapport au potentiel de masse,

e) un dispositif de production d'un plasma à proximité ou sur la surface de l'échantillon dont la contre-électrode (**2**) est espacée, de sorte que, lors du fonctionnement du dispositif, le plasma se trouve entre l'échantillon à mesurer et la contre-électrode (**2**), et

f) une unité d'évaluation qui permet de déterminer, à partir du potentiel $U_1$ appliqué à la contre-électrode (**2**), le potentiel $\varphi_{OF}$ à la surface de l'échantillon qui est mise en contact par zones avec le plasma, par l'intermédiaire de la relation

$$\varphi_{OF} = U_1 \cdot K_{CAIT,}$$

le facteur de calibrage $K_{CAIT}$ étant un facteur de calibrage déterminé expérimentalement.

Fig. 1A

Fig. 1B

Fig. 2

Fig. 3

Fig. 4

Fig. 5

Fig. 6

Fig. 7

Fig. 8

Fig. 9

Fig. 10

Fig. 11

Fig. 12

Fig. 13

**IN DER BESCHREIBUNG AUFGEFÜHRTE DOKUMENTE**

**In der Beschreibung aufgeführte Patentdokumente**

- DE 4132562 A1

**In der Beschreibung aufgeführte Nicht-Patentliteratur**

- **M. SCHÄFER ; K.-M. WEITZEL.** *Phys. Chem. Chem. Phys.,* 2011, vol. 13, 20112-20122
- **P. V. MENEZES et al.** *Phys. Chem. Chem. Phys.,* 2011, vol. 13, 20123-20128
- *Phys. Chem. Chem. Phys.,* 2017, vol. 19, 9762-9769